# EUROPÄISCHE PATENTSCHRIFT

(11) **EP 0 938 749 B1**
(45) Veröffentlichungstag und Bekanntmachung des Hinweises auf die Patenterteilung: **03.01.2007**
(21) Anmeldenummer: 97910206.8
(22) Anmeldetag: 15.09.1997
(51) Int. Cl.: H01L 23/50

(54) **INTEGRIERTE SCHALTUNG MIT EINEM DIESE IN SICH AUFNEHMENDEN GEHÄUSE**
INTEGRATED CIRCUIT WITH HOUSING ACCOMMODATING THE LATTER
CIRCUIT INTEGRE MUNI D'UN BOITIER LE CONTENANT

(30) Priorität: 18.09.1996 DE 19638175
(43) Veröffentlichungstag der Anmeldung: 01.09.1999
(73) Patentinhaber: Infineon Technologies AG, 81669 München (DE)
(72) Erfinder: SYRI, Erich, D-93173 Wenzenbach (DE); RÖMER, Bernd, D-93170 Bernhardswald (DE)
(74) Vertreter: Epping - Hermann - Fischer
(86) Internationale Anmeldenummer: PCT/DE1997/002067
(87) Internationale Veröffentlichungsnummer: WO 1998/012747

(56) Entgegenhaltungen:
- EP-A- 0 571 749
- WO-A-97/14183
- PATENT ABSTRACTS OF JAPAN vol. 010, no. 306 (E-446), 17.Oktober 1986 -& JP 61 120454 A (SONY CORP), 7.Juni 1986,
- PATENT ABSTRACTS OF JAPAN vol. 018, no. 171 (E-1529), 23.März 1994 -& JP 05 343579 A (TOSHIBA CORP;OTHERS: 01), 24.Dezember 1993,
- PATENT ABSTRACTS OF JAPAN vol. 017, no. 085 (E-1322), 19.Februar 1993 -& JP 04 280695 A (HITACHI LTD), 6.Oktober 1992,
- SINCLAIR I.: 'PRACTICAL ELECTRONICS HANDBOOK', 1980, NEWNES TECHNICAL BOOKS, UK * Seite 170 *

## Beschreibung

Die vorliegende Erfindung betrifft eine integrierte Schaltung mit einem diese in sich aufnehmenden Gehäuse gemäß dem Oberbegriff des Patentanspruchs 1, d.h. eine integrierte Schaltung mit einem diese in sich aufnehmenden Gehäuse, wobei die integrierte Schaltung durch selektives Vorsehen von elektrischen Verbindungen zwischen bestimmten, auf dieser ausgebildeten Kontaktstellen wahlweise in eine von mehreren verschiedenen Betriebsarten versetzbar ist.

Eine derartige, nachfolgend kurz als "Baustein" bezeichnete Einheit ist beispielsweise (aber nicht ausschließlich) ein Speicherbaustein, der beispielsweise (aber wiederum nicht ausschließlich) zur Montage auf einem SIMM (Single In-line Memory Module) vorgesehen ist.

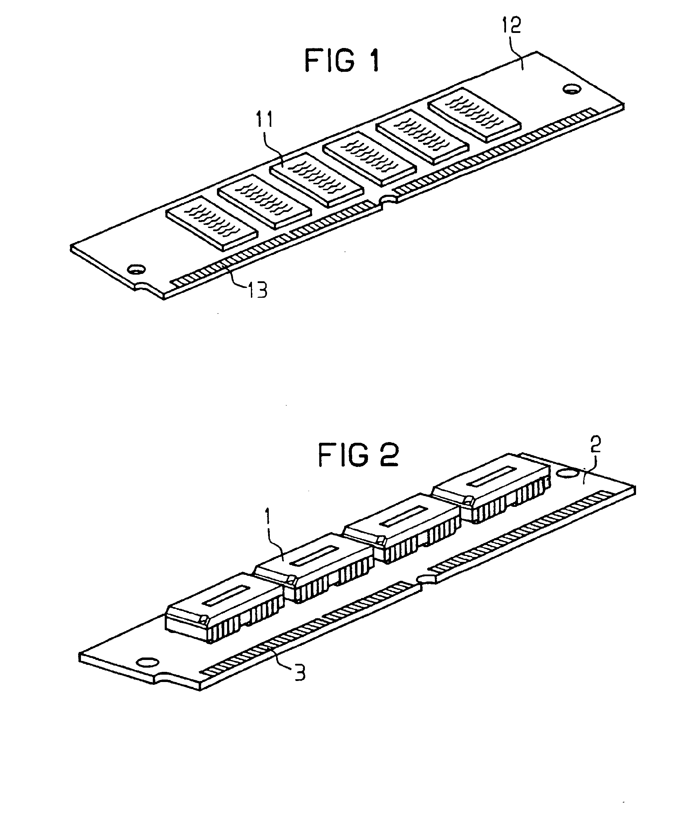

Ein mit herkömmlichen Speicherbausteinen bestücktes SIMM ist in der Figur 2 gezeigt. Die besagten Speicherbausteine, die dort mit dem Bezugszeichen 1 bezeichnet sind, sind auf eine Leiterplatte 2 aufgelötet. Die Leiterplatte 2 ist entlang einer ihrer Kanten mit einer Vielzahl von nebeneinander liegenden Kontaktelementen 3 versehen, so daß sie auf eine in der Figur nicht gezeigte weitere Leiterplatte, genauer gesagt in einen auf derselben vorgesehenen Leiterplattensteckverbin der steckbar ist.

Eine bekanntes Anwendungsgebiet für derartige SIMMs sind Personal Computer, wobei die SIMMs hier als Hauptspeicher-Module eingesetzt werden.

Die besagten Speicherbausteine existieren bekanntermaßen in einer Vielzahl von Varianten, die sich sowohl hinsichtlich des Gehäuses als auch hinsichtlich Ihrer Organisationsformen und Arbeitsmodi unterscheiden.

Die verschiedenen Organisationsformen wirken sich insbesondere auf die Größe der Einheiten aus, in denen die im jeweiligen Speicherbaustein zu speichernden bzw. dort gespeicherten Daten einzugeben sind bzw. ausgegeben werden. Genauer gesagt wird durch die Organisationsform unter anderem festgelegt, wieviel Bits oder Bytes ein einzelnes einzugebendes oder ausgegebenes Datum jeweils umfaßt (umfassen darf bzw. muß). In Abhängigkeit davon kann auch die Adresse variieren, die an den Speicherbaustein anzulegen ist, um auf einen bestimmten Speicherbereich zugreifen zu können.

Die verschiedenen Arbeitsmodi wirken sich unter anderem auf die Ansteuerung des jeweiligen Speicherbausteins und dessen besondere Reaktion darauf aus. Verschiedene Arbeitsmodi sind beispielsweise der EDO(enhanced bzw. extended data out)-Modus, FPM (fast page mode), verschiedene Arten von Refresh-Zyklen etc.

Die Organisationsform und die Arbeitsmodi sind an die jeweilige äußere Beschaltung des Speicherbausteins (den diese ansteuernden Controller) anzupassen (oder umgekehrt).

Die verschiedenen Gehäuse unterscheiden sich hinsichtlich der Anzahl ihrer Anschlußelemente (z.B. Pins), insbesondere hinsichtlich der von der gewählten Organisationsform abhängenden Anzahl der Anschlußelemente zur Adreß- und Datenein- und/oder -ausgabe, und hinsichtlich der Art und Weise ihrer Montierbarkeit auf Leiterplatten.

Das Gehäuse der in der Figur 2 gezeigten Speicherbausteine 1 ist ein für Speicherbausteine sehr häufig verwendetes, sogenanntes SOJ-Gehäuse, welches seinerseits ebenfalls wieder in verschiedenen, unterschiedlich viele Anschlußelemente aufweisenden Ausführungsformen gefertigt wird.

Die Vielzahl von verschiedenen Gehäusen sowie die Vielzahl der verschiedenen Organisationsformen und Arbeitsmodi der integrierten Schaltungen erfordern erkennbar häufige Umstellungen (Material- und Werkzeugwechsel) bei der Herstellung der Speicherbausteine und machen eine effiziente Lagerhaltung nahezu unmöglich.

Es wurde daher dazu übergegangen, integrierte Schaltungen herzustellen und zu verwenden, die nach deren Herstellung hinsichtlich deren Organisationsform und deren Arbeitsmodi mehr oder weniger frei konfigurierbar, also für eine Vielzahl von verschiedenen (Speicher-)Bausteinen einsetzbar sind.

Die besagte Konfigurierung kann dabei beispielsweise dadurch bewerkstelligt werden, daß selektiv zwischen bestimmten der auf der integrierten Schaltung ausgebildeten Kontaktstellen elektrische Verbindungen vorgesehen werden. Diese elektrischen Verbindungen sind innerhalb des Gehäuses vorgesehene, beispielsweise durch Bonden hergestellte Drahtverbindungen (Verdrahtungen).

Durch derartige Verdrahtungen, die vorzugsweise erst einhergehend mit der Unterbringung der integrierten Schaltung in das nach wie vor an die individuellen Erfordernisse angepaßte Gehäuse ausgeführt werden, kann die integrierte Schaltung je nach Bedarf in verschiedene Betriebsarten versetzt werden, durch welche ihr jeweils eine ganz bestimmte Organisationsform und ganz bestimmte Arbeitsmodi zugeordnet werden.

Das Vorsehen ein- und derselben integrierten Schaltung als Ausgangsprodukt für eine Vielzahl von verschiedenartig arbeitenden Speicherbausteinen und deren erst am Ende des Herstellungsprozesses erfolgende Konfigurierung (Individualisierung) vereinfacht die Herstellung der verschiedenen Speicherbausteine enorm.

Nichtsdestotrotz gestaltet sich die Herstellung derartiger Speicherbausteine nach wie vor als relativ umständlich, denn die Konfiguration der integrierten Schaltung kann in Abhängigkeit von der Gestaltung des Gehäuses, in dem die integrierte Schaltung unterzubringen ist, eine unterschiedliche vorgehensweise und damit auch den Einsatz unterschiedlicher Werkzeuge erfordern.

In Patent Abstracts of Japan Vol. 010, No. 306 (E-446), 17. Oktober 1986 & JP A 61120454 ist eine Anordnung mit mehreren Speicherbausteinen offenbart. Zweck der Anordnung ist es, deren Speicherkapazität insgesamt zu erhöhen. Dazu sind mehrere individuelle Speicherbausteine vorgesehen, bei denen zwei oder mehr Kontrollanschlüsse dieselbe Kontrollfunktion vorgesehen und nebeneinander angeordnet sind. Dabei können zwei oder mehrere Anschlüsse in Kontaktlöcher eines gemeinsamen Sockels auf einer Leiterplatte eingeführt werden. Um bedarfsweise den jeweiligen Speicherbaustein elektrisch auswählen zu können, weist jeder Speicherbaustein zwei Kontrollanschlüsse auf. Beide Kontrollanschlüsse führen bei elektrischer Ansteuerung zur selben Kontrollfunktion, nämlich zur Auswahl des jeweiligen Speicherbausteins. Um die Speicherbausteine alternativ anwählen zu können, wird von jedem Speicherbaustein der jeweils alternative Kontaktanschluss entfernt. Somit kann der jeweilige Speicherbaustein angesteuert werden.

Aus Patent Abstracts of Japan Vol. 018, NO. 171 (E-1529), 23. März 1994 & JP-A-05 343579 ist ein Montage-Bord mit einem Verdrahtungsmuster und mit Ausnehmungen bekannt, um das Verdrahtungsmuster an vorgegebenen Stellen zu unterbrechen und/oder zu verbinden.

Der vorliegenden Erfindung liegt daher die Aufgabe zugrunde, die integrierte Schaltung mit dem diese in sich aufnehmenden Gehäuse gemäß dem Oberbegriff des Patentanspruchs 1 derart weiterzubilden, daß sich deren Herstellung noch weiter vereinheitlichen läßt.

Diese Aufgabe wird erfindungsgemäß durch die im Patentanspruch 1 beanspruchten Merkmale gelöst.

Demnach ist vorgesehen, daß sämtliche der für den Betrieb und die Konfiguration der integrierten Schaltung vorgesehenen Kontaktstellen derselben mit extern kontaktierbaren Anschlußelementen des Gehäuses verbunden sind.

Es werden also mit anderen Worten zu sämtlichen die Betriebsart bestimmend Kontaktstellen der integrierten Schaltung entsprechende Anschlußelemente des Gehäuses von außen her zugänglich gemacht. Dadurch ist zum einen die Vielfalt der verschiedenen Gehäusevarianten reduzierbar, und zum anderen ist die Konfiguration von universell einsetzbaren integrierten Schaltungen gänzlich aus dem Prozeß der Baustein-Herstellung herausnehmbar.

Auf diese Weise läßt sich die Baustein-Herstellung erheblich weiter vereinheitlichen als dies bisher der Fall ist.

Die Auswahl, welche der komplett nach außen verlängerten Kontaktstellen der integrierten Schaltung tatsächlich verwendet (mit einer äußeren Beschaltung oder untereinander verbunden) werden, ist durch die Leiterplatte treffbar, auf welcher die betreffenden Bausteine zu montieren sind. Dies kann beispielsweise (aber nicht ausschließlich) dadurch geschehen, daß die Leiterplatte nur mit solchen Anschlußstellen des Bausteins in Kontakt bringbar (verlötbar) ist, die für den geplanten Einsatz tatsächlich auch benötigt werden.

Auch die Konfiguration der integrierten Schaltung ist durch die Leiterplatte festlegbar. Hierzu ist es lediglich erforderlich, daß die Leiterplatte entsprechende Leiterbahnen enthält, die die zur Aktivierung einer bestimmten Betriebsart zu verbindenden Kontaktstellen der integrierten Schaltung, genauer gesagt die mit diesen verbundenen Anschlußstellen des Gehäuses verbinden.

Vorteilhafte Weiterbildungen der Erfindung sind Gegenstand der Unteransprüche.

Die Erfindung wird nachfolgend anhand eines Ausführungsbeispiels unter Bezugnahme auf die Zeichnung näher erläutert. Es zeigen
- Figur 1: eine perspektivische Darstellung eines mit erfindungsgemäß ausgebildeten Speicherbausteinen bestückten SIMM, und
- Figur 2: eine perspektivische Darstellung eines mit herkömmlich ausgebildeten Speicherbausteinen bestückten SIMM.

Die erfindungsgemäße integrierte Schaltung mit dem diese in sich aufnehmenden Gehäuse basiert grundsätzlich auf den selben integrierten Schaltungen wie dies bisher der Fall ist. D.h., die integrierten Schaltungen bedürfen keiner, jedenfalls keiner wesentlichen Veränderung.

Die Erfindung wird nachfolgend unter Bezugnahme auf ein SIMM beschrieben, das mit erfindungsgemäß ausgebildeten Speicherbausteinen bestückt ist. Mit den erfindungsgemäß ausgebildeten Bausteinen sind jedoch selbstverständlich auch sogenannte DIMMs (Dual Inline Memory Modules) bestückbar. Darüber hinaus ist die Erfindung auch bei Speicherbausteinen einsetzbar, die nicht zur SIMM- und/oder DIMM-Herstellung vorgesehen sind.

Die erfindungsgemäß ausgebildeten Speicherbausteine bestehen aus einer integrierten Schaltung und einem diese in sich aufnehmenden Gehäuse.

Die integrierte Schaltung ist ein Halbleiterchip, der (normalerweise entlang dessen Rändern) eine Vielzahl von Kontaktstellen aufweist. Die Kontaktstellen haben individuell verschiedene Funktionen. Teils (zum überwiegenden Teil) dienen sie zur Ein- und/oder Ausgabe von Versorgungsspannungen sowie Adreß-, Daten- und Steuersignalen, und teils zur Auswahl einer bestimmten Betriebsart der integrierten Schaltung, genauer gesagt zur Festlegung einer bestimmten Organisationsform und bestimmter Arbeitsmodi derselben.

Sämtliche Kontaktstellen der integrierten Schaltung, zumindest sämtliche für den Betrieb und die Konfiguration der integrierten Schaltung vorgesehene Kontaktstellen sind mit entsprechenden Anschlußelementen des Gehäuses verbunden und damit von außerhalb des jeweiligen Bausteins zugänglich.

Die am Gehäuse vorzusehenden Anschlußelemente sind dort in einer Anzahl vorgesehen, die im wesentlichen der Anzahl der Kontaktstellen der betreffenden integrierten Schaltung entspricht.

Die Kontaktstellen von integrierten Schaltungen der betrachteten Art waren bislang nur teilweise mit Anschlußelementen am Gehäuse verbunden. Genauer gesagt wurden jeweils nur diejenigen Kontaktstellen der integrierten Schaltung von außen her zugänglich gemacht, die für den jeweiligen Einsatzzweck unverzichtbar waren.

Die Anzahl der Anschlußelemente des Gehäuses ist folglich bei dem erfindungsgemäßen Baustein erheblich höher als bei vergleichbaren herkömmlichen Bausteinen.

Um zu verhindern, daß dadurch in gleichem Maß auch die Größe des betreffenden Bausteins steigt, werden vorzugsweise Gehäuseformen verwendet, die das Vorsehen einer maximalen großen Anzahl von Anschlußelementen pro Flächeneinheit erlaubt. Hierfür kommen in erster Linie solche Gehäuse in Frage, welche wie beispielsweise die sogenannten CSPs (chip scaled packages) nicht nur entlang der jeweiligen Ränder des Gehäuses, sondern zusätzlich auch weiter innen mit einer Leiterplatte verbindbaren (verlötbaren) Anschlußstellen (Anschlußreihen) versehen sind. Wenngleich die nachfolgenden Erläuterungen teilweise auf der Verwendung von CSPs als Gehäuse basieren, besteht hierauf keine Einschränkung; es können auch andere Gehäuse verwendet werden. Eine der möglichen Alternativen zu den CSPs sind die sogenannten BGAs (ball grid arrays).

Ein SIMM, das mit erfindungsgemäß in CSPs untergebrachten integrierten Schaltungen (Speicherbausteinen) bestückt ist, ist in Figur 1 gezeigt. Die Speicherbausteine, die dort mit dem Bezugszeichen 11 bezeichnet sind, sind auf eine Leiterplatte 12 aufgelötet. Die Leiterplatte 12 ist - wie die in der Figur 2 gezeigte herkömmliche Leiterplatte 2 - entlang einer ihrer Kanten mit einer Vielzahl von nebeneinander liegenden Kontaktelementen 13 versehen, so daß sie auf eine in der Figur nicht gezeigte weitere Leiterplatte, genauer gesagt in einen auf derselben vorgesehenen Leiterplattensteckverbinder steckbar ist.

Das Vorhandensein eines Gehäuses ist nämlich eine nicht unwesentliche Voraussetzung dafür, daß die integrierte Schaltung vor deren Montage auf die Leiterplatte einer umfassenden qualitativen und quantitativen Überprüfung und künstlichen Alterung unterzogen werden kann. Dadurch (und nur dadurch) kann zuverlässig gewährleistet werden, daß die auf einer Leiterplatte montierten Chips fehlerfrei sind und gleichwertige technische Eigenschaften (z.B. Reaktionszeiten bzw. Geschwindigkeiten) aufweisen.

Bei der zuvor erwähnten Chip-on-Board-Montage kommt es trotz aller Bemühungen nicht selten vor, daß fehlerhafte oder voneinander abweichende Eigenschaften aufweisende integrierte Schaltungen auf die Leiterplatte montiert werden. Wird ein solcher Mangel erst nach der Montage auf die Leiterplatte festgestellt, erfordert dessen Behebung, sofern eine solche überhaupt möglich ist, einen unverhältnismäßig hohen Aufwand, so daß die Nachteile der Chip-on-Board-Montage die scheinbaren Vorteile (geringe Größe und einfachere Herstellung der Bausteine) letztendlich überraschend überwiegen.

Dadurch, daß im wesentlichen alle Kontaktstellen der integrierten Schaltung mit entsprechenden Anschlußstellen des Gehäuses verbunden sind, zu sämtlichen Kontaktstellen also auch von außerhalb des jeweiligen Bausteins ein Kontakt hergestellt werden kann, bedarf es während der Herstellung des jeweiligen Bausteins keiner wie auch immer gearteten Individualisierung desselben. Diese kann vielmehr bis zu dessen Montage auf eine Leiterplatte oder noch weiter zurückgestellt werden.

Somit können die Bausteine unabhängig von deren späterer Verwendung (deren Organisationsform, Arbeitsmodi etc.) in einem vollkommen einheitlichen (keine individuellen Besonderheiten aufweisenden) Herstellungsprozeß gefertigt werden. Ferner entfällt (aus dem soeben genannten Grund) auch die Notwendigkeit, eine Vielzahl von unterschiedlich konfigurierten, für verschiedene Einsatzzwecke vorgesehene Bausteine auf Lager zu halten.

Die Konfigurierung der integrierten Schaltung kann durch die Leiterplatte selbst erfolgen, auf welche der jeweilige Baustein zu montieren ist.

Im einfachsten Fall weist die besagte Leiterplatte Leiterbahnen auf, über welche bei einem darauf montierten (aufgelöteten) Baustein elektrische Verbindungen zwischen den Kontaktstellen hergestellt werden, welche zur Einstellung einer bestimmten Betriebsart zu verbinden sind.

Zwischen Anschlußelementen des Gehäuses, die nicht miteinander zu verbinden sind, werden entweder keine diese verbindenden Leiterbahnen vorgesehen oder es wird ganz und gar auf eine Kontaktierung dieser Anschlußelemente durch die Leiterplatte verzichtet. Letzteres kann besonders einfach und zuverlässig dadurch erreicht werden, daß auf der Leiterplatte keine Anschlußstellen vorgesehen werden, mit welchen die betreffenden Anschlußelemente des Bausteins (Bausteingehäuses) verbindbar (verlötbar) sind. Entsprechendes gilt im übrigen beispielsweise auch für diejenigen Anschlußelemente des Bausteins, die Adreß- und/oder Datenleitungen repräsentieren, welche bei der (durch die Leiterplatte) eingestellten Konfiguration der integrierten Schaltung nicht benötigt werden.

Alternativ oder zusätzlich kann vorgesehen werden, das Herstellen und/oder Auftrennen der besagten Verbindungen durch manuelle oder elektrische Betätigung von auf der Leiterplatte vorgesehenen Schaltern oder dergleichen durchzuführen. Dadurch könnte die individuelle Konfiguration nicht nur noch weiter nach hinten verschoben werden, sondern sogar an wechselnde Anforderungen im praktischen Einsatz angepaßt werden.

Die beschriebene integrierte Schaltung mit dem diese in sich aufnehmenden Gehäuse ermöglicht es, daß auf der selben integrierten Schaltung basierende Bausteine jeweils erst nach deren Herstellung konfiguriert werden und mithin völlig unabhängig vom jeweiligen Verwendungszweck, also einheitlich ohne individuelle Besonderheiten herstellbar sind.

## Patentansprüche

1. Speicherbaustein mit einer integrierten Schaltung und mit einem diese in sich aufnehmenden Gehäuse, wobei die integrierte Schaltung über Verdrahtung wahlweise in eine von mehreren verschiedenen Betriebsarten versetzbar ist, durch welche ihr jeweils eine Organisationsform, mit welcher festgelegt wird, wie viel Bits und Bytes ein einzelnes einzugebendes oder auszugebendes Datum umfasst, und ein Arbeitsmodus, mit welchem die Ansteuerung des Speicherbausteins und dessen Reaktion darauf festgelegt wird, zugeordnet werden, wobei die Verdrahtung außerhalb der integrierten Schaltung erfolgt,
**dadurch gekennzeichnet,**
**daß** die Wahl der Betriebsart durch selektives Vorsehen von elektrischen Verbindungen zwischen bestimmten, auf der integrierten Schaltung ausgebildeten Kontaktstellen erfolgt und daß zu sämtlichen die Betriebsart bestimmenden Kontaktstellen der integrierten Schaltung entsprechende Anschlusselemente am Gehäuse vorhanden sind.

2. Speicherbaustein nach Anspruch 1,
**dadurch gekennzeichnet,**
**daß** es sich um einen zur Bestückung eines sogenannten Single-Inline-Memory-Moduls (SIMM) oder eines sogenannten Dual-Inline-Memory-Moduls (DIMM) geeigneten Speicherbaustein handelt.

3. Speicherbaustein nach Anspruch 1 oder 2,
**dadurch gekennzeichnet,**
**daß** das Gehäuse ein sogenanntes Chip Scaled Package (CSP) oder ein sogenanntes Ball Grid Array (BGA) ist.

4. Speicherbaustein nach einem der vorhergehenden Ansprüche,
**dadurch gekennzeichnet,**
**daß** alle Anschlußelemente des Gehäuses derart angeordnet sind, daß sie mit entsprechenden Anschlußstellen einer Leiterplatte verlötbar sind.

5. Speicherbaustein nach einem der vorhergehenden Ansprüche,
**dadurch gekennzeichnet,**
**daß** die durch Vorsehen elektrischer Verbindungen zwischen bestimmten Kontaktstellen der integrierten Schaltung wahlweise einstellbaren Betriebsarten zur dauerhaften Anpassung der integrierten Schaltungen an deren individuellen Einsatzort vorgesehen sind.

## Claims

1. Memory device with an integrated circuit and with a housing accommodating the latter within itself, it being possible for the integrated circuit to be put optionally, by means of wiring, into one of a plurality of different operating modes, by means of which it is respectively assigned an organizational form, which defines how many bits and bytes an individual data that are to be input or output comprises, and an operation mode, which defines the driving of the memory device and the latter's reaction thereto, the wiring being effected outside the integrated circuit,
**characterized**
**in that** the operating mode is chosen by selective provision of electrical connections between specific contact points formed on the integrated circuit,
and **in that** terminal elements corresponding to all the contact points of the integrated circuit which determine the operating mode are present at the housing.

2. Memory device according to claim 1,
**characterized**
**in that** what is involved is a memory device suitable for equipping a so-called single inline memory module (SIMM) or a so-called dual inline memory module (DIMM).

3. Memory device according to claim 1 or 2,
**characterized**
**in that** the housing is a so-called chip scaled package (CSP) or a so-called ball grid array (BGA).

4. Memory device according to one of the preceding claims,
**characterized**
**in that** all the terminal elements of the housing are arranged in such a way that they can be soldered to corresponding terminal points on a printed circuit board.

5. Memory device according to one of the preceding claims,
**characterized**
**in that** the operating modes which can optionally be set by virtue of the provision of electrical connections between specific contact points of the integrated circuit are provided for permanently adapting the integrated circuits to the individual location of use of said integrated circuits.

## Revendications

1. Module de mémoire comprenant un circuit intégré et un boîtier le contenant, le circuit intégré pouvant être par câblage mis au choix dans l'un de plusieurs types différents de fonctionnement, par lesquels il lui est associé, respectivement, une forme d'organisation par laquelle il est fixé combien de bits et d'octets comprend une donnée individuelle à entrer ou à sortir et un mode de travail par lequel il est fixé la commande du module de mémoire et sa réaction, le câblage s'effectuant à l'extérieur du circuit intégré,
**caractérisé en ce que** le choix du type de fonctionnement s'effectue en prévoyant sélectivement des liaisons électriques entre certains points de contact constitués sur le circuit intégré et **en ce qu'**il y a sur le boîtier des éléments de borne correspondant à l'ensemble des points de contact du circuit intégré déterminant le type de fonctionnement.

2. Module de mémoire suivant la revendication 1,
**caractérisé en ce que** c'est un module de mémoire approprié pour équiper ce que l'on appelle un Single-Inline-Memory-Moduls (SIMM) ou ce que l'on appelle un Dual-Inline-Memory-Moduls (DIMM).

3. Module de mémoire suivant la revendication 1 ou 2,
**caractérisé en ce que** le boîtier est ce que l'on appelle un Chip Scaled Package (CSP) ou ce que l'on appelle un Ball Grid Array (BGA).

4. Module de mémoire suivant l'une des revendications précédentes,
**caractérisé en ce que** tous les éléments de borne du boîtier sont disposés de manière à pouvoir être brasés à des points de borne correspondants d'une plaquette à circuit imprimé.

5. Module de mémoire suivant l'une des revendications précédentes,
**caractérisé en ce que** les types de fonctionnement pouvant être réglés à volonté en prévoyant des liaisons électriques en des points de contact du circuit intégré sont prévus pour l'adaptation durable des circuits intégrés à leur emplacement individuel d'utilisation.
